(19) Europäisches Patentamt / European Patent Office / Office européen des brevets

(11) **EP 4 024 518 A1**

(12) **EUROPEAN PATENT APPLICATION**
published in accordance with Art. 153(4) EPC

(43) Date of publication:
**06.07.2022 Bulletin 2022/27**

(21) Application number: **20940021.7**

(22) Date of filing: **11.12.2020**

(51) International Patent Classification (IPC):
$H01M\ 4/36$ [(2006.01)]    $H01M\ 4/505$ [(2010.01)]
$H01M\ 4/525$ [(2010.01)]    $H01M\ 4/62$ [(2006.01)]

(52) Cooperative Patent Classification (CPC):
Y02E 60/10

(86) International application number:
**PCT/CN2020/135524**

(87) International publication number:
**WO 2021/248860 (16.12.2021 Gazette 2021/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.06.2020  CN 202010526228**

(71) Applicant: **SVOLT ENERGY TECHNOLOGY CO., LTD**
**Changzhou, Jiangsu 213200 (CN)**

(72) Inventors:
 • **WANG, Pengfei**
  **hangzhou, Jiangsu 213200 (CN)**

 • **JIANG, Weijun**
  **hangzhou, Jiangsu 213200 (CN)**
 • **QIAO, Qiqi**
  **hangzhou, Jiangsu 213200 (CN)**
 • **SUN, Mingzhu**
  **hangzhou, Jiangsu 213200 (CN)**
 • **XU, Xinpei**
  **hangzhou, Jiangsu 213200 (CN)**
 • **SHI, Zetao**
  **hangzhou, Jiangsu 213200 (CN)**
 • **MA, Jiali**
  **hangzhou, Jiangsu 213200 (CN)**
 • **CHEN, Sixian**
  **hangzhou, Jiangsu 213200 (CN)**

(74) Representative: **Cabinet Beaumont**
 **4, Place Robert Schuman**
 **B.P. 1529**
 **38025 Grenoble Cedex 1 (FR)**

(54) **COBALT-FREE SINGLE CRYSTAL COMPOSITE MATERIAL, AND PREPARATION METHOD THEREFOR AND USE THEREOF**

(57)    A cobalt-free single crystal composite material, and a preparation method therefor and a use thereof. The cobalt-free single crystal material is of a core-shell structure, the core layer is the cobalt-free single crystal material, and the shell layer is prepared from $TiNb_2O_7$ and conductive lithium salt. The $TiNb_2O_7$ and the conductive lithium salt are selected as materials of the shell layer to coat the cobalt-free single crystal material, thereby improving the lithium ion conductivity of the cobalt-free single crystal material, and further improving the capacity and the first effect of the material.

| 2 µm | EHT = 10.00 kV | Signal A = InLens | Date :13 Apr 2020 | ZEISS |
| | WD = 2.8 mm | Mag = 2.00 K X | Time :9:13:56 | |

Figure 1

EP 4 024 518 A1

**Description**

TECHNICAL FIELD

The present disclosure relates to the field of batteries, for example, a cobalt-free single crystal composite material, a method for preparing the same and use thereof.

BACKGROUND

With the development of new energy sources, ternary cathode materials have been developed due to the advantages of a high energy density, a high cycle, high safety and the like. In the current power market, ternary materials such as NCM523 and NCM622, which are commercialized on a large scale, meet the requirements of power vehicles to some extent, and their range and safety are to be improved.

The price of cobalt in NCM fluctuates, which restricts the cost control of batteries. Cobalt is expensive and easy to pollute the environment. Polycrystalline NCM materials are mostly secondary particles formed through the agglomeration of primary particles of 200-300 nm, which increases a contact area with an electrolyte. During a cycle, microcracks easily occur inside the materials and increase with an increase in content of nickel so that more electrolytes permeate into the particles, causing more side reactions and damaging the structures of the materials.

A single crystal material is directly composed of individual crystals of 2-5 microns and has the characteristics of higher crystallinity and a more stable layered structure. However, a pure matrix material has a low capacity and a low cycle, which is mainly caused by poor conductivity of lithium ions in a cobalt-free single crystal material. Ion conductivity restricts a rate at which lithium ions migrate in and out in the charge and discharge processes of a battery so that the capacity of the material cannot function well. With more cycles, the battery increases in internal resistance and is prone to heat generation, which poses a great safety hazard.

CN109962223A discloses a lithium-ion battery containing a cobalt-free Ni-Mn solid solution nickel-based cathode material. A cathode active material is the cobalt-free Ni-Mn solid solution nickel-based cathode material coated with modified BN and has a structural formula of $LiNi_xMn_{1-x}O_2 \cdot aBN$, where $0.5 \leq x < 1$, $0 < a \leq 0.06$, and the modified BN is a coating layer on the surface of a material $LiNi_xMn_{1-x}O_2$. However, the cathode material has relatively poor lithium ion conductivity and a high cost.

CN103943844B discloses a cobalt-free lithium-rich manganese-based cathode material, a method for preparing the same and use thereof. The cathode material has a chemical formula of $Li_{1+x}Ni_yMn_{0.8-y}O_2$ ($0 < x < 1/3$, $0 < y < 0.8$). A process of preparing the cathode material includes: preparing a precursor in a solvent, ethanol or deionized water, by a sol-gel method, pre-sintering at a low temperature, ball-milling, and sintering at a high temperature in a solid state to obtain the prepared cathode material. However, the cathode material obtained by this method has relatively poor lithium ion conductivity.

Therefore, a novel cobalt-free single crystal material needs to be developed in the art, which has excellent lithium ion conductivity and a low cost, is prepared by a simple method and can be industrialized.

SUMMARY

The present disclosure provides a cobalt-free single crystal composite material, a method for preparing the same and use thereof.

In an embodiment, the present disclosure provides a cobalt-free single crystal composite material having a core-shell structure, where the core layer is of a cobalt-free single crystal material, and the shell layer is of a material formulation comprises $TiNb_2O_7$ and a conductive lithium salt.

In an embodiment provided by the present disclosure, $TiNb_2O_7$ and the conductive lithium salt are selected as the materials of the shell layer to be coated on the cobalt-free single crystal material, which facilitates the migration in and out of lithium ions inside the material in charge and discharge processes, improves the lithium ion conductivity of the cobalt-free single crystal material, and improves the capacity and initial effect of the material; the shell layer is conducive to reducing a contact area between the material and an electrolyte and slows down a side reaction between the material and the electrolyte, improving cycle performance of the material. $TiNb_2O_7$ and the conductive lithium salt cooperate with each other so that the best technical effect can be achieved. If the material of the shell layer includes only $TiNb_2O_7$, the structure of $TiNb_2O_7$ will be destroyed due to a reaction of the shell layer with the electrolyte as the cycling progresses. The conductive lithium salt in the shell layer can inhibit the side reaction with the electrolyte and enhance the stability of a coating material. However, the presence of only the conductive lithium salt in the shell layer cannot improve the lithium ion conductivity through co-coating.

In an embodiment, the cobalt-free single crystal material has a chemical formula of $Li_mNi_xMn_yMnO_2$, where $0.4 \leq x \leq 0.95$, for example, 0.45, 0.5, 0.55, 0.6, 0.65, 0.7, 0.75, 0.8, 0.85, or 0.9, *etc.*; $0.05 \leq y \leq 0.6$, for example, 0.1, 0.15, 0.2, 0.25, 0.3, 0.35, 0.4, 0.45, 0.5, or 0.55, *etc.*; and m is 1.05 to 1.5, for example, 1.1, 1.15, 1.2, 1.25, 1.3, 1.35, 1.4, or 1.45, *etc.*

In an embodiment, the conductive lithium salt includes at least one of $LiH_2PO_4$, $CaF_2$, TiN, TiC, $LiAlO_2$ and BiO-YO.

In an embodiment, the conductive lithium salt is $LiH_2PO_4$.

In an embodiment, in the shell layer, a molar ratio of $TiNb_2O_7$ to the conductive lithium salt is (0.1-10): 1, for example, 0.5: 1, 1: 1, 1.5: 1, 2: 1, 2.5: 1, 3: 1, 3.5: 1, 4: 1, 4.5: 1, 5: 1, 5.5: 1, 6: 1, 6.5: 1, 7: 1, 7.5: 1, 8: 1, 8.5: 1, 9: 1, or 9.5: 1, *etc.*

In the embodiment provided by the present disclosure, the molar ratio of $TiNb_2O_7$ to the conductive lithium salt is (0.1-10): 1. Too high a content of $TiNb_2O_7$ and too low a content of the conductive lithium salt increase the cost of the composite material and cause the shell layer to be easily destroyed during cycling. Too high a content of the conductive lithium salt and too low a content of $TiNb_2O_7$ result in poor lithium ion conductivity of the composite material. Therefore, $TiNb_2O_7$ and the conductive lithium salt can exert a better synergistic effect and achieve the best technical effect only within a ratio range provided by the embodiment of the present disclosure.

In an embodiment, the shell layer accounts for a ratio of 0.1-0.5wt%, for example, 0.15wt%, 0.2wt%, 0.25wt%, 0.3wt%, 0.35wt%, 0.4wt%, or 0.45wt%, *etc.*, in the cobalt-free single crystal composite material.

In an embodiment, the core layer accounts for a ratio of 99.5-99.9wt%, for example, 99.55wt%, 99.6wt%, 99.65wt%, 99.7wt%, 99.75wt%, 99.8wt%, or 99.85wt%, *etc.*, in the cobalt-free single crystal composite material.

In an embodiment, the cobalt-free single crystal composite material has a particle size D50 of 1-5 $\mu$m, for example, 1.5 $\mu$m, 2 $\mu$m, 2.5 $\mu$m, 3 $\mu$m, 3.5 $\mu$m, 4 $\mu$m, or 4.5 $\mu$m, *etc.*

In an embodiment, the cobalt-free single crystal composite material has a specific surface area of 0.3-1.5 $m^2/g$, for example, 0.4 $m^2/g$, 0.5 $m^2/g$, 0.6 $m^2/g$, 0.7 $m^2/g$, 0.8 $m^2/g$, 0.9 $m^2/g$, 1.0 $m^2/g$, 1.1 $m^2/g$, 1.2 $m^2/g$, 1.3 $m^2/g$, or 1.4 $m^2/g$, *etc.*

In an embodiment, the cobalt-free single crystal composite material has a surface pH of 11.8 or below (for example, 7.5, 8, 8.5, 9, 9.5, 10, 10.5, 11, or 11.5, *etc.*) and 3500 ppm or below (for example, 1000 ppm, 1500 ppm, 2000 ppm, 2500 ppm, or 3000 ppm, *etc.*) of total alkalis.

In an embodiment, the present disclosure provides a method for preparing the cobalt-free single crystal composite material, including:
mixing a cobalt-free single crystal material, $TiNb_2O_7$ and a conductive lithium salt, and carrying out sintering to obtain the cobalt-free single crystal composite material.

In an embodiment, a method for preparing the cobalt-free single crystal material includes: mixing a lithium salt and a precursor of the cobalt-free single crystal material, and carrying out calcination to obtain the cobalt-free single crystal material.

In an embodiment, the precursor of the cobalt-free single crystal material has a chemical formula of $Ni_aMn_b(OH)_2$, where $0.4 \leq a \leq 0.95$, for example, 0.45, 0.5, 0.55, 0.6, 0.65, 0.7, 0.75, 0.8, 0.85, or 0.9, *etc.*; and $0.05 \leq b \leq 0.6$, for example, 0.1, 0.15, 0.2, 0.25, 0.3, 0.35, 0.4, 0.45, 0.5, or 0.55, *etc.*

In an embodiment, the lithium salt includes lithium hydroxide and/or lithium carbonate.

In an embodiment, a ratio of a molar amount of lithium in the lithium salt to a molar amount of total metal elements in the precursor of the cobalt-free single crystal material is 1.05-1.5, for example, 1.1, 1.15, 1.2, 1.25, 1.3, 1.35, 1.4, or 1.45, *etc.*

In an embodiment, the lithium salt and the precursor of the cobalt-free single crystal material are mixed under stirring.

In an embodiment, the mixing under stirring is carried out at a rotational speed of 1500-2500 rpm, for example, 1600 rpm, 1700 rpm, 1800 rpm, 1900 rpm, 2000 rpm, 2100 rpm, 2200 rpm, 2300 rpm, or 2400 rpm, *etc.*

In an embodiment, the mixing under stirring is carried out for 5-15 min, for example, 6 min, 7 min, 8 min, 9 min, 10 min, 11 min, 12 min, 13 min, or 14 min, *etc.*

In an embodiment, the calcination is carried out in an oxygen atmosphere.

In an embodiment, oxygen in the oxygen atmosphere has a concentration greater than or equal to 99.99%.

In an embodiment, oxygen in the oxygen atmosphere has a flowrate of 5-10 L/min, for example, 5.5 L/min, 6 L/min, 6.5 L/min, 7 L/min, 7.5 L/min, 8 L/min, 8.5 L/min, 9 L/min, or 9.5 L/min, *etc.*

In an embodiment, the calcination is carried out at a temperature of 850-1000 °C, for example, 880 °C, 900 °C, 920 °C, 940 °C, 950 °C, 960 °C, or 980 °C, *etc.*

In an embodiment, the calcination is carried out at a temperature ramp rate of 3-5 °C/min, for example, 3.2 °C/min, 3.5 °C/min, 3.8 °C/min, 4 °C/min, 4.2 °C/min, 4.5 °C/min, or 4.8 °C/min, *etc.*

In an embodiment, the calcination is carried out for 8-20 h, for example, 10 h, 12 h, 14 h, 15 h, 16 h, or 18 h, *etc.*

In an embodiment, after the calcination, the method further includes cooling, crushing and sieving.

In an embodiment, the sieving is carried out with a 300-400 mesh sieve, for example, 300 mesh, 310 mesh, 320 mesh, 330 mesh, 340 mesh, 350 mesh, 360 mesh, 370 mesh, 380 mesh, 390 mesh, or 400 mesh, *etc.*

In an embodiment, a ratio of a total mass of $TiNb_2O_7$ and the conductive lithium salt to a weight of the cobalt-free single crystal material is 1000-3000 pmm, for example, 1200 pmm, 1500 pmm, 1600 pmm, 1800 pmm, 2000 pmm, 2200 pmm, 2500 pmm, or 2800 pmm, *etc.*

In the embodiment provided by the present disclosure, the ratio of the total mass of $TiNb_2O_7$ and the conductive lithium salt to the weight of the cobalt-free single crystal material is 1000-3000 pmm. If the total mass of $TiNb_2O_7$ and the conductive lithium salt is too large, the coating layer increases in thickness and the capacity cannot function well. If the total mass of $TiNb_2O_7$ and the conductive lithium salt is too small, the stability of the material is improved to a relatively small degree.

In an embodiment, a molar ratio of $TiNb_2O_7$ to the conductive lithium salt is (0.1-10): 1, for example, 0.5: 1, 1: 1, 1.5: 1, 2: 1, 2.5: 1, 3: 1, 3.5: 1, 4: 1, 4.5: 1, 5: 1, 5.5: 1, 6: 1, 6.5: 1, 7: 1, 7.5: 1, 8: 1, 8.5: 1, 9: 1, or 9.5: 1, *etc.*

In an embodiment, a process of mixing the cobalt-free single crystal material, $TiNb_2O_7$ and the conductive lithium salt includes: mixing and dissolving $TiNb_2O_7$ and the conductive lithium salt in deionized water, drying the mixture, and mixing the mixture and the cobalt-free single crystal material.

In the embodiment provided by the present disclosure, $TiNb_2O_7$ and the conductive lithium salt are mixed, dissolved in the deionized water, and dried so that the conductive lithium salt and $TiNb_2O_7$ can be uniformly dispersed, and then the resultant is mixed with the cobalt-free single crystal material so that the conductive lithium salt and $TiNb_2O_7$ are uniformly dispersed on the surface of the cobalt-free single crystal material, which is conducive to improving the electrochemical performance of the product.

In an embodiment, the mixing is carried out in a handheld stirrer.

In an embodiment, the mixing is carried out for 10-20 min, for example, 11 min, 12 min, 13 min, 14 min, 15 min, 16 min, 17 min, 18 min, or 19 min, *etc.*

In an embodiment, the sintering is carried out in an oxygen atmosphere.

In an embodiment, oxygen in the oxygen atmosphere has a concentration greater than or equal to 99.99%.

In an embodiment, oxygen in the oxygen atmosphere has a flowrate of 5-10 L/min, for example, 5.5 L/min, 6 L/min, 6.5 L/min, 7 L/min, 7.5 L/min, 8 L/min, 8.5 L/min, 9 L/min, or 9.5 L/min, *etc.*

In an embodiment, the sintering is carried out at a temperature of 300-700 °C, for example, 350 °C, 400 °C, 450 °C, 500 °C, 550 °C, 600 °C, or 650 °C, *etc.*

In the embodiment provided by the present disclosure, the sintering is carried out at a temperature of 300-700 °C. Too low a temperature causes coating to be not firm and easy to fall off in later cycles. Too high a temperature causes the coating material to decompose so that a coating effect cannot be achieved.

In an embodiment, the sintering is carried out at a temperature ramp rate of 3-5 °C/min, for example, 3.2 °C/min, 3.5 °C/min, 3.8 °C/min, 4 °C/min, 4.2 °C/min, 4.5 °C/min, or 4.8 °C/min, *etc.*

In an embodiment, the sintering is carried out for 6-12 h, for example, 8 h, 10 h, 12 h, 14 h, 15 h, 16 h, or 18 h, *etc.*

In an embodiment, after the sintering, the method further includes cooling, crushing and sieving.

In an embodiment, the method includes the following steps:

(1) mixing a lithium salt and a precursor of the cobalt-free single crystal material under stirring at a rotational speed of 1500-2500 rpm for 5-15 min, where a ratio of a molar amount of lithium in the lithium salt to a molar amount of total metal elements in the precursor of the cobalt-free single crystal material is 1.05-1.5; carrying out calcination for 8-20 h at a temperature of 850-1000 °C and in an oxygen atmosphere with a flowrate of 5-10 L/min, where the calcination is carried out at a temperature ramp rate of 3-5 °C/min; and cooling, crushing and sieving with a 300-400 mesh sieve to obtain the cobalt-free single crystal material; and

(2) mixing and dissolving $TiNb_2O_7$ and $LiH_2PO_4$ at a molar ratio of (0.1-10): 1 in deionized water, drying the mixture, and mixing the mixture and the cobalt-free single crystal material for 10-20 min in a handheld stirrer, where a ratio of a total mass of $TiNb_2O_7$ and $LiH_2PO_4$ to a weight of the cobalt-free single crystal material is 1000-3000 pmm; carrying out sintering for 6-12 h at a temperature of 300-700 °C and in an oxygen atmosphere with a flowrate of 5-10 L/min, where the sintering is carried out at a temperature ramp rate of 3-5 °C/min; and cooling, crushing and sieving to obtain the cobalt-free single crystal composite material.

In an embodiment, the present disclosure provides a cathode sheet including the cobalt-free single crystal composite material according to an embodiment of the present disclosure.

In an embodiment, the present disclosure provides a lithium-ion battery including the cathode sheet according to an embodiment of the present disclosure.

BRIEF DESCRIPTION OF DRAWINGS

The drawings are used to provide a further understanding of technical solutions of the present disclosure, constitute a part of the description, explain the technical solutions of the present disclosure in conjunction with embodiments of the present application and do not limit the technical solutions of the present disclosure.

FIGS. 1 and 2 are scanning electron microscopic (SEM) images of a cobalt-free single crystal composite material prepared in an example of the present disclosure.

FIGS. 3 and 4 are SEM images of a cobalt-free single crystal material prepared in Comparative Example 1 of the present disclosure.

DETAILED DESCRIPTION

Technical solutions of the present disclosure are further described below through embodiments in conjunction with drawings.

**Example 1**

A method for preparing a cobalt-free single crystal composite material includes steps described below.

(1) LiOH powder and a precursor $Ni_{0.75}Mn_{0.25}(OH)_2$ of a cobalt-free single crystal material were mixed under stirring at a rotational speed of 2000 rpm for 10 min, where a ratio of a molar amount of lithium in LiOH to a molar amount of total metal elements in the precursor $Ni_{0.75}Mn_{0.25}(OH)_2$ of the cobalt-free single crystal material was 1.1; calcination was carried out for 10 h at a temperature of 900 °C and in an oxygen atmosphere with a flowrate of 8 L/min, where the calcination was carried out at a temperature ramp rate of 4 °C/min; and the calcined substance was cooled, crushed and sieved with a 300 mesh sieve to obtain a cobalt-free single crystal material.

(2) $TiNb_2O_7$ and $LiH_2PO_4$ were mixed and dissolved in deionized water at a molar ratio of 1: 1, dried, and mixed with the cobalt-free single crystal material for 15 min in a handheld stirrer, where a ratio of a total mass of $TiNb_2O_7$ and $LiH_2PO_4$ to a weight of the cobalt-free single crystal material was 1000 pmm; sintering was carried out for 8 h at a temperature of 500 °C and in an oxygen atmosphere with a flowrate of 8 L/min, where the sintering was carried out at a temperature ramp rate of 4 °C/min; and the sintered substance was cooled, crushed and sieved to obtain a cobalt-free single crystal composite material.

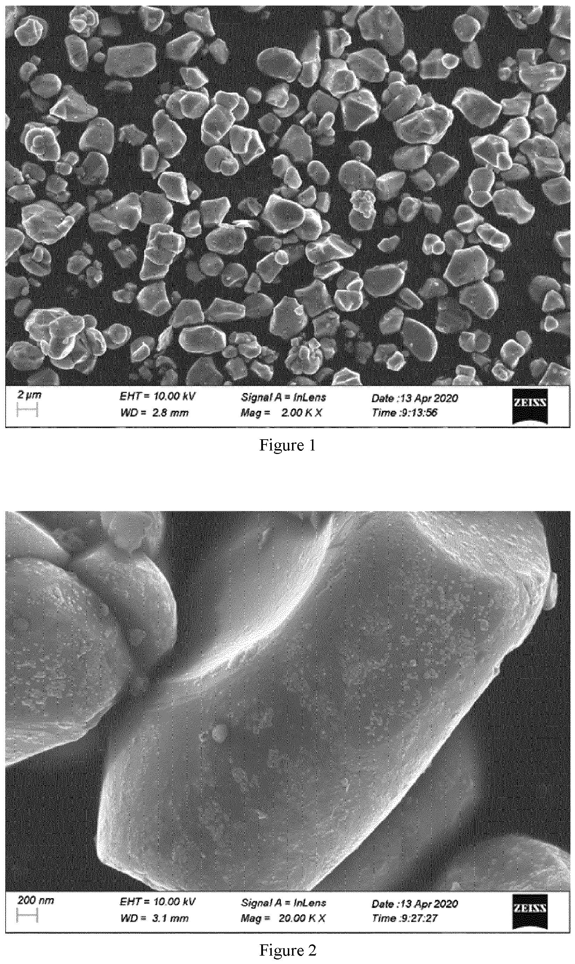

FIGS. 1 and 2 are SEM images of the cobalt-free single crystal composite material provided in this example. It can be seen from the figures that the single crystal materials synthesized in this example have good morphology, uniform particle distribution and a particle size of 1-5 $\mu$m.

**Example 2**

This example differs from Example 1 in that in step (2), the ratio of the total mass of $TiNb_2O_7$ and $LiH_2PO_4$ to the weight of the cobalt-free single crystal material was 2000 pmm.

**Example 3**

This example differs from Example 1 in that in step (2), the ratio of the total mass of $TiNb_2O_7$ and $LiH_2PO_4$ to the weight of the cobalt-free single crystal material was 3000 pmm.

**Example 4**

This example differs from Example 1 in that in step (2), the ratio of the total mass of $TiNb_2O_7$ and $LiH_2PO_4$ to the weight of the cobalt-free single crystal material was 500 pmm.

**Example 5**

This example differs from Example 1 in that in step (2), the molar ratio of $TiNb_2O_7$ and $LiH_2PO_4$ was 0.1: 1.

**Example 6**

This example differs from Example 1 in that in step (2), the molar ratio of $TiNb_2O_7$ and $LiH_2PO_4$ was 0.05: 1.

**Example 7**

This example differs from Example 1 in that in step (2), the molar ratio of $TiNb_2O_7$ and $LiH_2PO_4$ was 12: 1.

**Example 8**

A method for preparing a cobalt-free single crystal composite material includes steps described below.

(1) LiOH powder and a precursor $Ni_{0.75}Mn_{0.25}(OH)_2$ of a cobalt-free single crystal material were mixed under stirring at a rotational speed of 2500 rpm for 5 min, where a ratio of a molar amount of lithium in LiOH to a molar amount of total metal elements in the precursor $Ni_{0.75}Mn_{0.25}(OH)_2$ of the cobalt-free single crystal material was 1.3; calcination was carried out for 20 h at a temperature of 850 °C and in an oxygen atmosphere with a flowrate of 10 L/min, where the calcination was carried out at a temperature ramp rate of 3 °C/min; and the calcined substance was cooled, crushed and sieved with a 400 mesh sieve so that the cobalt-free single crystal material was obtained.

(2) $TiNb_2O_7$ and $LiH_2PO_4$ were mixed and dissolved in deionized water at a molar ratio of 8: 1, dried, and mixed with the cobalt-free single crystal material for 20 min in a handheld stirrer, where a ratio of a total mass of $TiNb_2O_7$ and $LiH_2PO_4$ to a weight of the cobalt-free single crystal material was 1500 pmm; sintering was carried out for 6 h at a temperature of 700 °C and in an oxygen atmosphere with a flowrate of 10 L/min, where the sintering was carried out at a temperature ramp rate of 5 °C/min; and the sintered substance was cooled, crushed and sieved so that the cobalt-free single crystal composite material was obtained.

The cobalt-free single crystal composite material obtained in this example has electrochemical performance similar to that of Example 1.

**Comparative Example 1**

The cobalt-free single crystal material obtained in step (1) of Example 1 was used.

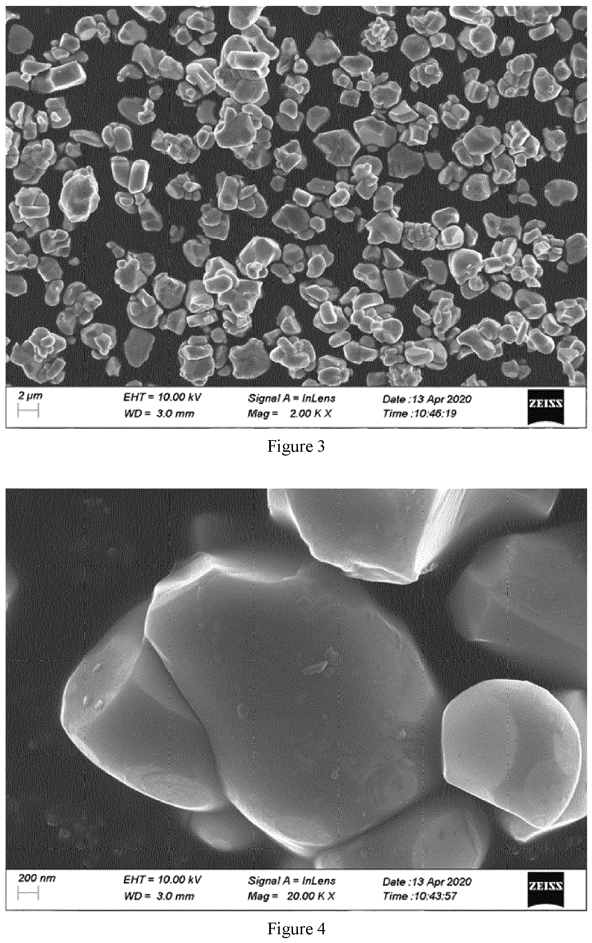

FIGS. 3 and 4 are SEM images of the cobalt-free single crystal material provided in this comparative example. It can be seen from the figures that a particle size of the cobalt-free single crystal material is not significantly different from that of Example 1, indicating that coating in Example 1 has no effect on the particle size of the material.

Performance Test

The cobalt-free single crystal composite materials (the cobalt-free single crystal material in Comparative Example 1) obtained in examples and comparative examples were assembled as a cathode active material into batteries.

A cathode slurry was prepared according to a ratio 92: 4: 4 of the cathode active material: conductive carbon black SP: a polyvinylidene fluoride (PVDF) glue solution (with a solid content of 6.05%), and coated on an aluminum foil so that a cathode sheet was obtained.

Then, an anode sheet (lithium sheet), the cathode sheet, an electrolyte (lithium hexafluorophosphate ($LiPF_6$) of 1 mol/L and ethylene carbonate (EC): ethyl methyl carbonate (EMC) = 1: 1) and a separator were assembled into the battery.

(1) Test of electrochemical performance: The obtained battery was charged and discharged in an environment of $25 \pm 2$ °C at a charge/discharge voltage of 3-4.4 V in order to measure the initial charge specific capacity at 0.1C, the initial discharge specific capacity at 0.1C, the initial discharge specific capacity at 1C, the initial efficiency (0.1C) and the capacity retention rate after 50 cycles (1C). The results are shown in Table 1.

(2) Test of powder resistance: Three samples were taken in parallel for each group of the cobalt-free single crystal composite materials (the cobalt-free single crystal material in Comparative Example 1) obtained in Examples 1 to 3 and Comparative Example 1, where 3.5 g were weighed for each group. The cobalt-free single crystal composite materials (the cobalt-free single crystal material in Comparative Example 1) were loaded into molds (drained with a funnel to prevent the material from being hung on the wall) and flattened. The molds were mounted on a device and started to be tested. Equal pressure was applied until 4KN, 8KN, 12KN and 16KN, separately. After the pressure was stabilized, values of resistivity were measured (an average value was obtained for each group). The results are shown in Table 2.

(3) Galvanostatic intermittent titration technique (GITT) test: The batteries obtained in Examples 1 to 3 and Comparative Example 1 were charged and discharged (three batteries were used for each group and named 1, 2 and 3 respectively).

After the test, a lithium ion diffusion coefficient was calculated by using the formula $D = \frac{4}{\pi \Delta \tau} \left( \frac{m_B V_M}{M_B S} \right)^2 \left( \frac{\Delta E_S}{\Delta E_\tau} \right)^2$,

where $m_B$ denotes a mass (g) of an active material, $M_B$ denotes a molar mass (g/mol), $V_M$ denotes a molar volume ($cm^3$/mol), S denotes a sheet area ($cm^2$), $\triangle E_S = E_0 - E_S$, and $\triangle t = 300s$. The results are shown in Table 3.

Table 1

|  | Initial Charge Specific Capacity at 0.1C (mAh/g) | Initial Discharge Specific Capacity at 0.1C (mAh/g) | Initial Discharge Specific Capacity at 1C (mAh/g) | Initial Efficiency (%) | Capacity Retention Rate after 50 Cycles (%) |
|---|---|---|---|---|---|
| Example 1 | 222.5 | 193.7 | 175 | 87.06 | 97.1 |
| Example 2 | 223.1 | 196.2 | 177.2 | 87.94 | 98.1 |
| Example 3 | 221.4 | 194.1 | 173.2 | 87.67 | 97.3 |
| Example 4 | 218.0 | 189.2 | 172.0 | 86.78 | 97.1 |
| Example 5 | 218.1 | 188.0 | 172.2 | 86.20 | 96.6 |
| Example 6 | 217.2 | 188.5 | 170.1 | 86.79 | 95.2 |
| Example 7 | 218.5 | 188.1 | 170.2 | 86.09 | 95.5 |
| Comparative Example 1 | 219 | 190.2 | 172.4 | 86.85 | 96.2 |

Table 2

|  | 4KN ($\Omega\cdot$cm) | 8KN ($\Omega\cdot$cm) | 12KN ($\Omega\cdot$cm) | 16KN ($\Omega\cdot$cm) |
|---|---|---|---|---|
| Example 1 | $2.69\times10^5$ | $1.31\times10^4$ | $8.07\times10^4$ | $5.80\times10^4$ |
| Example 2 | $3.08\times10^5$ | $9.39\times10^4$ | $4.04\times10^4$ | $2.57\times10^3$ |
| Example 3 | $3.16\times10^5$ | $1.20\times10^4$ | $5.68\times10^3$ | $3.33\times10^3$ |
| Comparative Example 1 | $3.15\times10^5$ | $9.01\times10^4$ | $4.24\times10^4$ | $2.59\times10^4$ |

The values of the lithium ion diffusion coefficients D in Example 1, Example 2, Example 3 and Comparative Example 1 are listed in Table 3. Parameters during calculation of the lithium ion diffusion coefficients D (P in Table 4 denotes a density of the active material) are listed in Table 4.

Table 3

|  | D ($cm^2$/s) | | | Average Value of D ($cm^2$/s) |
|---|---|---|---|---|
|  | 1 | 2 | 3 | |
| Example 1 | $1.90\times10^{-8}$ | $1.71\times10^{-8}$ | $1.35\times10^{-8}$ | $1.65\times10^{-8}$ |
| Example 2 | $1.52\times10^{-8}$ | $1.95\times10^{-8}$ | $1.14\times10^{-8}$ | $1.54\times10^{-8}$ |
| Example 3 | $1.62\times10^{-8}$ | $1.90\times10^{-8}$ | $1.32\times10^{-8}$ | $1.62\times10^{-8}$ |
| Comparative Example 1 | $3.37\times10^{-9}$ | $4.40\times10^{-9}$ | $9.90\times10^{-9}$ | $5.89\times10^{-9}$ |

Table 4

| | | $m_B(g)$ | MB(g/m ol) | P(g/c m$^3$) | S(cm $^2$) | Eo | Es | $\triangle E$ s | $\triangle t$( s) | $\triangle E_\tau$ |
|---|---|---|---|---|---|---|---|---|---|---|
| Example 1 | 1 | 0.0093 84 | 97 | 4.66 | 1.13 04 | 4.4 | 4.3 49 | 0.0 51 | 300 | 0.0 43 |
| | 2 | 0.0093 84 | 97 | 4.66 | 1.13 04 | 4.3 49 | 4.3 31 | 0.0 18 | 300 | 0.0 16 |
| | 3 | 0.0093 84 | 97 | 4.66 | 1.13 04 | 4.3 31 | 4.3 16 | 0.0 15 | 300 | 0.0 15 |
| Example 2 | 1 | 0.0092 92 | 97 | 4.66 | 1.13 04 | 4.4 | 4.3 56 | 0.0 44 | 300 | 0.0 41 |
| | 2 | 0.0092 92 | 97 | 4.66 | 1.13 04 | 4.3 56 | 4.3 39 | 0.0 17 | 300 | 0.0 14 |
| | 3 | 0.0092 92 | 97 | 4.66 | 1.13 04 | 4.3 39 | 4.3 26 | 0.0 13 | 300 | 0.0 14 |
| Example 3 | 1 | 0.0092 92 | 97 | 4.66 | 1.13 04 | 4.4 | 4.3 59 | 0.0 41 | 300 | 0.0 37 |
| | 2 | 0.0092 92 | 97 | 4.66 | 1.13 04 | 4.3 59 | 4.3 41 | 0.0 18 | 300 | 0.0 15 |
| | 3 | 0.0092 92 | 97 | 4.66 | 1.13 04 | 4.3 41 | 4.3 29 | 0.0 12 | 300 | 0.0 12 |
| Comparat ive Example 1 | 1 | 0.0093 84 | 97 | 4.66 | 1.13 04 | 3.8 55 | 3.8 51 | 0.0 04 | 300 | 0.0 08 |
| | 2 | 0.0093 84 | 97 | 4.66 | 1.13 04 | 3.8 51 | 3.8 47 | 0.0 04 | 300 | 0.0 07 |
| | 3 | 0.0093 84 | 97 | 4.66 | 1.13 04 | 3.8 47 | 3.8 41 | 0.0 06 | 300 | 0.0 07 |

As can be seen from Table 1, the coated material has an improved capacity and an improved cycle performance relative to the uncoated material (Comparative Example 1), where coating has optimal effects in the case of 2000 ppm.

As can be seen from Table 2, the materials obtained in the examples and the comparative example vary in the order of magnitude of resistivity under different pressure, and the coating structure of the present disclosure improves electron conductivity of the cobalt-free single crystal material.

As can be seen from Table 3, the lithium ion diffusion coefficient of the uncoated material (Comparative Example 1) has a power of -9 and has a power of -8 after coating, which is improved by one order of magnitude. It indicates that coating agents, $TiNb_2O_7$ and the conductive lithium salt, are conducive to improving the ion conductivity of the material, thereby improving the electrochemical performance of the material.

As can be seen from the comparison between Example 1 and Example 4, the capacity of the material cannot function well in the case of a small amount of coating.

As can be seen from the comparison of Example 1 with Examples 6 and 7, too large a molar ratio or too small a molar ratio both result in poor electrochemical performance of the obtained product, and $TiNb_2O_7$ and the conductive lithium salt can better exert a synergistic effect to improve the electrochemical performance of the cobalt-free single crystal material only when the molar ratio of $TiNb_2O_7$ and conductive lithium salt is (0.1-10): 1.

The cobalt-free single crystal composite material obtained in Example 8 of the present disclosure has electrochemical performance similar to that of Example 1.

As can be seen from the comparison of Example 1 with Comparative Example 1, the use of the coating structure of the present disclosure for coating the cobalt-free single crystal material can effectively improve the specific capacity, initial efficiency and cycle performance of the cobalt-free single crystal material.

## Claims

1. A cobalt-free single crystal composite material having a core-shell structure, wherein the core layer is of a cobalt-free single crystal material, and the shell layer is of a material formulation comprises $TiNb_2O_7$ and a conductive lithium salt.

2. The cobalt-free single crystal composite material according to claim 1, wherein the cobalt-free single crystal material has a chemical formula of $Li_mNi_xMn_yMnO_2$, wherein $0.4 \leq x \leq 0.95$, $0.05 \leq y \leq 0.6$, and m is 1.05 to 1.5.

3. The cobalt-free single crystal composite material according to claim 1 or 2, wherein the conductive lithium salt comprises at least one of $LiH_2PO_4$, $CaF_2$, TiN, TiC, $LiAlO_2$ and BiO-YO.

4. The cobalt-free single crystal composite material according to claim 3, wherein the conductive lithium salt is $LiH_2PO_4$.

5. The cobalt-free single crystal composite material according to any one of claims 1 to 4, wherein in the shell layer, a molar ratio of $TiNb_2O_7$ to the conductive lithium salt is (0.1-10): 1.

6. The cobalt-free single crystal composite material according to any one of claims 1 to 5, wherein the shell layer accounts for a ratio of 0.1-0.5wt% in the cobalt-free single crystal composite material.

7. The cobalt-free single crystal composite material according to any one of claims 1 to 6, wherein the core layer accounts for a ratio of 99.5-99.9wt% in the cobalt-free single crystal composite material.

8. The cobalt-free single crystal composite material according to any one of claims 1 to 7, wherein the cobalt-free single crystal composite material has a particle size D50 of 1-5 $\mu$m.

9. The cobalt-free single crystal composite material according to any one of claims 1 to 8, wherein the cobalt-free single crystal composite material has a specific surface area of 0.3-1.5 $m^2$/g.

10. The cobalt-free single crystal composite material according to any one of claims 1 to 9, wherein the cobalt-free single crystal composite material has a surface pH of 11.8 or below and 3500 ppm or below of total alkalis.

11. A method for preparing the cobalt-free single crystal composite material according to any one of claims 1 to 10, comprising:
mixing a cobalt-free single crystal material, $TiNb_2O_7$ and a conductive lithium salt, and carrying out sintering to obtain the cobalt-free single crystal composite material.

12. The method according to claim 11, wherein a method for preparing the cobalt-free single crystal material comprises:
mixing a lithium salt and a precursor of the cobalt-free single crystal material, and carrying out calcination to obtain the cobalt-free single crystal material.

13. The method according to claim 12, wherein the precursor of the cobalt-free single crystal material has a chemical formula of $Ni_aMn_b(OH)_2$, wherein $0.4 \leq a \leq 0.95$ and $0.05 \leq b \leq 0.6$.

14. The method according to claim 12 or 13, wherein the lithium salt comprises lithium hydroxide and/or lithium carbonate.

15. The method according to any one of claims 12 to 14, wherein a ratio of a molar amount of lithium in the lithium salt to a molar amount of total metal elements in the precursor of the cobalt-free single crystal material is 1.05-1.5.

16. The method according to any one of claims 12 to 15, wherein the lithium salt and the precursor of the cobalt-free single crystal material are mixed under stirring.

17. The method according to claim 16, wherein the mixing under stirring is carried out at a rotational speed of 1500-2500 rpm.

18. The method according to claim 16 or 17, wherein the mixing under stirring is carried out for 5-15 min.

19. The method according to any one of claims 12 to 18, wherein the calcination is carried out in an oxygen atmosphere.

20. The method according to claim 19, wherein oxygen in the oxygen atmosphere has a concentration greater than or equal to 99.99%.

21. The method according to claim 19 or 20, wherein oxygen in the oxygen atmosphere has a flowrate of 5-10 L/min.

22. The method according to any one of claims 12 to 21, wherein the calcination is carried out at a temperature of 850-1000 °C.

23. The method according to any one of claims 12 to 22, wherein the calcination is carried out at a temperature ramp rate of 3-5 °C/min.

24. The method according to any one of claims 12 to 23, wherein the calcination is carried out for 8-20 h.

**25.** The method according to any one of claims 12 to 24, after the calcination, further comprising cooling, crushing and sieving.

**26.** The method according to claim 25, wherein the sieving is carried out with a 300-400 mesh sieve.

**27.** The method according to any one of claims 11 to 26, wherein a ratio of a total mass of $TiNb_2O_7$ and the conductive lithium salt to a weight of the cobalt-free single crystal material is 1000-3000 pmm.

**28.** The method according to any one of claims 11 to 27, wherein a molar ratio of $TiNb_2O_7$ to the conductive lithium salt is (0.1-10): 1.

**29.** The method according to any one of claims 11 to 28, wherein a process of mixing the cobalt-free single crystal material, $TiNb_2O_7$ and the conductive lithium salt comprises: mixing and dissolving $TiNb_2O_7$ and the conductive lithium salt in deionized water, drying the mixture, and mixing the mixture and the cobalt-free single crystal material.

**30.** The method according to any one of claims 11 to 29, wherein the mixing is carried out in a handheld stirrer.

**31.** The method according to any one of claims 11 to 30, wherein the mixing is carried out for 10-20 min.

**32.** The method according to any one of claims 11 to 31, wherein the sintering is carried out in an oxygen atmosphere.

**33.** The method according to claim 32, wherein oxygen in the oxygen atmosphere has a concentration greater than or equal to 99.99%.

**34.** The method according to claim 32 or 33, wherein oxygen in the oxygen atmosphere has a flowrate of 5-10 L/min.

**35.** The method according to any one of claims 11 to 34, wherein the sintering is carried out at a temperature of 300-700 °C.

**36.** The method according to any one of claims 11 to 35, wherein the sintering is carried out at a temperature ramp rate of 3-5 °C/min.

**37.** The method according to any one of claims 11 to 36, wherein the sintering is carried out for 6-12 h.

**38.** The method according to any one of claims 11 to 37, after the sintering, further comprising cooling, crushing and sieving.

**39.** The method according to any one of claims 11 to 38, comprising the following steps:

(1) mixing a lithium salt and a precursor of the cobalt-free single crystal material under stirring at a rotational speed of 1500-2500 rpm for 5-15 min, wherein a ratio of a molar amount of lithium in the lithium salt to a molar amount of total metal elements in the precursor of the cobalt-free single crystal material is 1.05-1.5; carrying out calcination for 8-20 h at a temperature of 850-1000 °C and in an oxygen atmosphere with a flowrate of 5-10 L/min, wherein the calcination is carried out at a temperature ramp rate of 3-5 °C/min; and cooling, crushing and sieving with a 300-400 mesh sieve to obtain the cobalt-free single crystal material; and
(2) mixing and dissolving $TiNb_2O_7$ and $LiH_2PO_4$ at a molar ratio of (0.1-10): 1 in deionized water, drying the mixture, and mixing the mixture and the cobalt-free single crystal material for 10-20 min in a handheld stirrer, wherein a ratio of a total mass of $TiNb_2O_7$ and $LiH_2PO_4$ to a weight of the cobalt-free single crystal material is 1000-3000 pmm; carrying out sintering for 6-12 h at a temperature of 300-700 °C and in an oxygen atmosphere with a flowrate of 5-10 L/min, wherein the sintering is carried out at a temperature ramp rate of 3-5 °C/min; and cooling, crushing and sieving to obtain the cobalt-free single crystal composite material.

**40.** A cathode sheet, comprising the cobalt-free single crystal composite material according to any one of claims 1 to 10.

**41.** A lithium-ion battery, comprising the cathode sheet according to claim 40.

Figure 1

Figure 2

Figure 3

Figure 4

| INTERNATIONAL SEARCH REPORT | International application No. |
|---|---|
| | **PCT/CN2020/135524** |

**A. CLASSIFICATION OF SUBJECT MATTER**

H01M 4/36(2006.01)i; H01M 4/505(2010.01)n; H01M 4/525(2010.01)n; H01M 4/62(2006.01)i

According to International Patent Classification (IPC) or to both national classification and IPC

**B. FIELDS SEARCHED**

Minimum documentation searched (classification system followed by classification symbols)

H01M

Documentation searched other than minimum documentation to the extent that such documents are included in the fields searched

Electronic data base consulted during the international search (name of data base and, where practicable, search terms used)

CNPAT, WPI, EPODOC, CNKI, WEB OF SCIENCE: 正极, 阴极, 富锂, 固溶体, 包覆, 被覆, 覆盖, 复合, 层, 壳, 核, 铌酸钛, cathode, positive, shell, clad???, layer?, cover???, coat???, core?, composite, niobate, TiNb2O7, LiH2PO4, CaF2, TiN, TiC, LiAlO2, BiO-YO

**C. DOCUMENTS CONSIDERED TO BE RELEVANT**

| Category* | Citation of document, with indication, where appropriate, of the relevant passages | Relevant to claim No. |
|---|---|---|
| PX | CN 111682175 A (SVOLT ENERGY TECHNOLOGY CO., LTD.) 18 September 2020 (2020-09-18) claims 1-10 | 1-41 |
| Y | CN 102496710 A (HUNAN SHANSHAN TODA ADVANCED MATERIALS CO.,LTD.) 13 June 2012 (2012-06-13) description, paragraphs 2-10, 25 | 1-41 |
| Y | CN 110277554 A (NORTHERN ALTAIR NANOTECHNOLOGIES CO., LTD. et al.) 24 September 2019 (2019-09-24) description, paragraphs 4-31 | 1-41 |
| Y | CN 103828096 A (ASAHI GLASS CO., LTD.) 28 May 2014 (2014-05-28) description paragraphs 44-194 | 1-41 |
| A | CN 109860588 A (SVOLT ENERGY TECHNOLOGY CO., LTD.) 07 June 2019 (2019-06-07) entire document | 1-41 |
| A | JP 2011238523 A (TOYOTA MOTOR CORP. et al.) 24 November 2011 (2011-11-24) entire document | 1-41 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **20 February 2021** | **10 March 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088** **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/135524**

| Patent document cited in search report | | | Publication date (day/month/year) | Patent family member(s) | | | Publication date (day/month/year) |
|---|---|---|---|---|---|---|---|
| CN | 111682175 | A | 18 September 2020 | None | | | |
| CN | 102496710 | A | 13 June 2012 | CN | 102496710 | B | 08 January 2014 |
| CN | 110277554 | A | 24 September 2019 | None | | | |
| CN | 103828096 | A | 28 May 2014 | US | 10326127 | B2 | 18 June 2019 |
| | | | | US | 2014212758 | A1 | 31 July 2014 |
| | | | | CN | 106972167 | A | 21 July 2017 |
| | | | | WO | 2013047877 | A1 | 04 April 2013 |
| | | | | EP | 2763217 | A1 | 06 August 2014 |
| | | | | JP | 6064909 | B2 | 25 January 2017 |
| | | | | EP | 2763217 | A4 | 01 April 2015 |
| | | | | KR | 102008542 | B1 | 07 August 2019 |
| | | | | US | 2019245202 | A1 | 08 August 2019 |
| | | | | JP | WO2013047877 | A1 | 30 March 2015 |
| | | | | KR | 20140076555 | A | 20 June 2014 |
| CN | 109860588 | A | 07 June 2019 | None | | | |
| JP | 2011238523 | A | 24 November 2011 | JP | 5552360 | B2 | 16 July 2014 |

Form PCT/ISA/210 (patent family annex) (January 2015)

**EP 4 024 518 A1**

**REFERENCES CITED IN THE DESCRIPTION**

**Patent documents cited in the description**

- CN 109962223 A
- CN 103943844 B